# EUROPÄISCHE PATENTSCHRIFT

(11) **EP 2 894 100 B1**
(45) Veröffentlichungstag und Bekanntmachung des Hinweises auf die Patenterteilung: **11.05.2016**
(21) Anmeldenummer: 14151132.9
(22) Anmeldetag: 14.01.2014
(51) Int. Cl.: B65B 31/02, B65B 57/18

(54) **Vakuum-Kammermaschine mit Federbrucherkennung und entsprechendes Verfahren**
Vacuum chamber machine with spring fracture detection and corresponding method
Machine à cloche sous vide avec détection de rupture de ressort et méthode correspondante

(43) Veröffentlichungstag der Anmeldung: 15.07.2015
(73) Patentinhaber: MULTIVAC Sepp Haggenmüller SE & Co. KG, 87787 Wolfertschwenden (DE)
(72) Erfinder: Mößnang, Konrad, 87439 Kempten (DE); Friedl, Jonas, 86971 Peiting (DE)
(74) Vertreter: Grünecker Patent- und Rechtsanwälte PartG mbB

(56) Entgegenhaltungen:
- EP-A1- 0 945 347
- EP-A1- 1 403 185
- DE-A1- 19 850 613
- US-A- 5 465 557

## Beschreibung

Die Erfindung bezieht sich auf eine Verpackungsmaschine in Form einer Vakuum-Kammermaschine gemäß dem Oberbegriff des Anspruchs 1 und ein Verfahren zum Ermitteln eines Federbruchs bei einer Vakuum-Kammermaschine gemäß den Merkmalen des Anspruchs 12.

Es ist aus der CN 202783871 U eine Vakuum-Kammermaschine bekannt, die ein manuelles Öffnen und Schließen eines Kammerdeckels offenbart, wobei eine Zugfeder zur Gewichtsentlastung des Kammerdeckels vorgesehen ist. Sollte die Zugfeder brechen, so würde der Bediener dies bereits beim Öffnen des Kammerdeckels bemerken. Aus der US 5465557 ist eine Vakuum-Kammermaschine gemäss dem Oberbegriff des Anspruchs 1 bekannt.

Es sind Vakuum-Kammermaschinen vom Typ C700 der Anmelderin selbst auf dem Markt, die eine motorisch angetriebene Kammerdeckelschwenkbewegung aufweisen. Zur Gewichtsentlastung des Kammerdeckels sind Zugfedern vorgesehen, da solche Kammermaschinen aufgrund ihrer zum Teil sehr großen Abmessungen einen Kammerdeckel mit einem Gewicht mit bis zu 200kg aufweisen können. Bei solchen motorisch angetriebenen Kammerdeckeln ist ein Schutzrahmen vorgesehen, der dazu konfiguriert ist, beim Schließen eine Relativbewegung zum Kammerdeckel hin auszuführen, wenn sich beispielsweise ein Körperteil des Bedieners in der Kammermaschine im Bereich des Kammerdeckels befindet. Mittels Sensoren wird die Relativbewegung des Schutzrahmens gegenüber dem Kammerdeckel erkannt und die Steuerung hält den motorischen Kammerdeckelantrieb an und verhindert somit eine Verletzung. Dabei muss der Kammerdeckel innerhalb des Schutzrahmens zum Stillstand kommen. Hierzu ist es nötig, die kinetische Energie der Masse des Kammerdeckels um einen Drehpunkt des Kammerdeckels innerhalb eines entsprechenden Drehwinkels abzubauen. Hierzu sind mehrere Zugfedern vorgesehen, um den motorischen Kammerdeckelantrieb zu unterstützen bzw. einen Gewichtsausgleich zu schaffen. Sollte es während des Betriebs zu einem Federbruch kommen, so kann dies der Bediener kaum feststellen, da sich der Kammerdeckel meist immer noch automatisch öffnet und wieder schließt. Im Gefahrenfall, bei dem der Schutzrahmen auslöst, ist der Kammerdeckel weniger unterstützt und der Kammerdeckel kann nicht mehr durch den Motor rechtzeitig zum Stillstand gebracht werden und eine Verletzung ist nicht mehr auszuschließen.

Aufgabe der vorliegenden Erfindung ist es, eine Vakuum-Kammermaschine mit einer kraftbetrieben Kammerdeckelschwenkbewegung bezüglich ihrer Sicherheit zu verbessern.

Diese Aufgabe wird gelöst durch eine Vakuum-Kammermaschine mit den Merkmalen des Anspruchs 1 bzw. durch ein Verfahren zum Ermitteln eines Federbruchs mit den Merkmalen des Anspruchs 12. Vorteilhafte Weiterbildungen der Erfindung sind in den Unteransprüchen angegeben.

Die erfindungsgemäße Vakuum-Kammermaschine umfasst ein Gestell, eine Steuerung und einen Kammerdeckel, wobei der Kammerdeckel mittels eines kraftbetriebenen Antriebs schwenkbar ist, wobei mehrere Federn vorgesehen sind, um den Antrieb wirkungsmäßig zu unterstützen. Die Vakuum-Kammermaschine zeichnet sich dadurch aus, dass jede der Federn als Teil eines eigenen oder für mehrere Federn gemeinsamen Stromkreises derart mit der Steuerung verbunden ist, dass durch eine Änderung des Stroms oder der Spannung ein Federbruch erkennbar ist. Mit dieser Prüfung kann die Sicherheit der Verpackungsmaschine erhöht werden, da ansonsten bei herkömmlichen Vakuum-Kammermaschinen bei einem motorischen Antrieb für das Schwenken des Kammerdeckels der Bruch einer einzigen Feder nicht erkannt werden könnte. Ist ein Schutzrahmen am Kammerdeckel vorgesehen, so wäre sonst trotz des Schutzrahmens ein sicheres Abschalten der Kammerdeckelbewegung im Gefahrenfall nicht mehr gewährleistet.

Bevorzugt sind dabei die Federn elektrisch isoliert an Federhaltern angebracht, um mit einer konstruktiv einfachen Ausführung die Federn als Teile der ersten elektrischen Leitung zu implementieren und auswerten zu können.

Dabei sind die Federhalter vorzugsweise selbst auch elektrisch isoliert gegenüber dem Gestell und den Federn in der Vakuum-Kammermaschine angeordnet.

In einer vorteilhaften Ausgestaltung sind ein, mehrere oder alle Federhalter mittels eines zweiten elektrischen Stromkreises in Reihe miteinander und mit der Steuerung elektrisch verbunden, um eine fehlerhafte Isolierung wenigstens einer Feder an einem Federhalter ermitteln zu können, denn eine oder mehrere fehlerhafte Isolationen an den Federn können dazu führen, dass trotz einer gebrochen Feder die Federbrucherkennung dies nicht erkennt.

Die Federn sollten aus einem Metall bestehen, beispielsweise aus Edelstahl, um einen ausreichenden Federkoeffizienten sowie eine möglichst hohe elektrische Leitfähigkeit aufzuweisen.

Günstig ist es, wenn ein möglichst langer Bereich der Feder als Teil des elektrischen Stromkreises herangezogen wird. Beispielsweise könnte dafür die gesamte Länge der Feder verwendet werden, oder zumindest der Abschnitt der Feder zwischen zwei Federhaltern, da dies der Bereich ist, in dem ein Federbruch die Sicherheit der Verpackungsmaschine beeinträchtigen könnte.

Denkbar wäre es, dass jede Feder als Teil eines eigenen Stromkreises mit der Steuerung verbunden ist. Effizienter kann es jedoch unter Umständen sein, wenn mehrere Federn oder sogar alle Federn als Teil eines gemeinsamen Stromkreises mit der Steuerung verbunden sind. Denkbar ist es auch, dass jeweils Gruppen von mehreren Federn mittels eines eigenen Stromkreises mit der Steuerung verbunden sind.

Wenn mehrere Federn mittels eines gemeinsamen Stromkreises mit der Steuerung verbunden sind, ist es vorteilhaft für die Messung, wenn diese Federn in Reihe miteinander elektrisch verbunden sind. Denn in diesem Fall würde der Stromfluss durch den gesamten Stromkreis unterbrochen, wenn schon in einer einzigen Feder ein Federbruch auftritt, der die Sicherheit der Verpackungsmaschine beeinträchtigen könnte.

Vorzugsweise ist die Steuerung dazu konfiguriert, bei Erkennen eines Federbruchs den Antrieb abzuschalten oder eine Schließbewegung des Kammerdeckels nicht zuzulassen und/oder eine Fehlerinformation an einer Anzeige der Steuerung auszugeben, damit der Bediener das Problem beheben kann und die Sicherheit wieder hergestellt ist.

Der Antrieb weist bevorzugt einen Spindelmotor, einen Servomotor oder einen Linearmotor auf.

Der Antrieb ist in vorteilhafter Weise über einen Fußtaster und/oder die Steuerung aktivierbar, um die Bedienung der Vakuum-Kammermaschine zu verbessern.

Der Kammerdeckel umfasst in einer vorteilhaften Ausführung einen Schutzrahmen, um beim Schließen des Kammerdeckels ein Körperteil wie einen Arm im Bereich des Schutzrahmens zu erfassen, um einen Not-Halt einzuleiten und die Deckelbewegung anzuhalten.

Das erfindungsgemäße Verfahren zum Ermitteln eines Federbruchs in einer Vakuum-Kammermaschine sieht mehrere Federn zum Unterstützen eines kraftbetrieben Antriebs zum Schwenken eines Kammerdeckels vor. Dabei ist jede der Federn über einen erste elektrischen Stromkreis mit einer Steuerung verbunden und der Stromkreis ist an einer ersten Ausgangsklemme sowie an einer ersten Eingangsklemme der Steuerung angeschlossen. Das Verfahren weist folgende Schritte auf:
- Anlegen einer elektrischen Spannung an der ersten Ausgangsklemme,
- Prüfen, ob an der ersten Eingangsklemme die Spannung anliegt oder ein Strom fließt,
- Freigabe des Antriebs für den Kammerdeckel durch die Steuerung, wenn eine vorgegebene Spannung anliegt oder an der ersten Ausgangsklemme dieselbe Stromstärke vorliegt wie an der ersten Eingangsklemme.
Somit kann auf eine konstruktiv einfache Weise und mit einem geringen Aufwand seitens der Steuerung die Sicherheit der Vakuum-Kammermaschine für Mensch und Maschine bezüglich des kraftbetrieben Schwenkantriebs erhöht werden.

In einer besonders vorteilhaften Ausgestaltung sieht das Verfahren folgende Schritte zur Prüfung der Isolation von Federn gegenüber von Federhaltern vor, wobei die Federhalter über eine zweite elektrische Leitung in Reihe miteinander verbunden sind und die zweite Leitung mit einer zweiten Ausgangsklemme und mit einer zweiten Eingangsklemme der Steuerung verbunden ist:
- Anlegen einer elektrischen Spannung an der ersten Ausgangsklemme,
- Prüfen, ob an der ersten Eingangsklemme und an der zweiten Eingangsklemme eine Spannung anliegt oder ein Strom fließt,
- Freigabe des Antriebs, falls kein Federbruch und keine defekte Isolation einer Feder durch die Steuerung festgestellt wurde,
- Ausgabe einer Fehlerinformation an einer Anzeige der Steuerung, falls ein Federbruch oder eine defekte Isolation einer Feder durch die Steuerung festgestellt wurde, wobei der Antrieb nicht freigegeben wird.

Der Zustand "kein Federbruch und keine defekte Isolation" kann entweder dadurch erkannt werden, dass eine Stromstärkenmessung an der ersten Eingangsklemme dieselbe Stromstärke wie an der ersten Ausgangsklemme misst, oder dass an der ersten Eingangsklemme eine um den Spannungsabfall an den Federn im Vergleich zur Spannung an der ersten Ausgangsklemme verringerte Spannung anliegt. Ein Federbruch kann erkannt werden, indem an der ersten Eingangsklemme eine andere als die vorstehend geschilderte, erwartete Spannung anliegt, oder indem an der ersten Eingangsklemme keinerlei Stromfluss messbar ist. Eine defekte Isolation einer Feder kann erkannt werden, indem an der zweiten Eingangsklemme ein Stromfluss festgestellt wird. Denkbar ist es, dass diese Feststellung jeweils durch das Vergleichen mit einem vorgegebenen Schwellenwert erfolgt.

Somit wird die Federbrucherkennung über den ersten Stromkreis dahingehend verbessert, dass selbst eine defekte, aber für die Federbrucherkennung notwendige Isolation an den Federn erkannt und die Sicherheit des Gesamtsystem weiter verbessert wird.

Vorzugsweise beträgt die an der ersten Ausgangsklemme anliegende elektrische Spannung 20V bis 35V, beispielsweise 24V.

Der Antrieb erfolgt bevorzugt mittels eines motorischen Antriebs, vorzugsweise eines Spindelmotors, Servomotors oder eines Linearmotors.

In einer besonders vorteilhaften Ausführung wird der Antrieb über einen Fußtaster und/oder die Steuerung aktiviert, um die Bedienung der Vakuum-Kammermaschine zu verbessern, vor allem zum Schließen des Kammerdeckels.

Im Folgenden wird ein vorteilhaftes Ausführungsbeispiel der Erfindung anhand einer Zeichnung näher erläutert. Im Einzelnen zeigen:
- Fig. 1: eine erfindungsgemäße Vakuum-Kammermaschine mit geöffnetem Kammerdeckel,
- Fig. 2: die Vakuum-Kammermaschine mit offengelegtem Innenraum,
- Fig. 3: eine Ansicht der Federanordnung von unten.

Gleiche Komponenten sind in den Figuren durchgängig mit gleichen Bezugszeichen versehen.

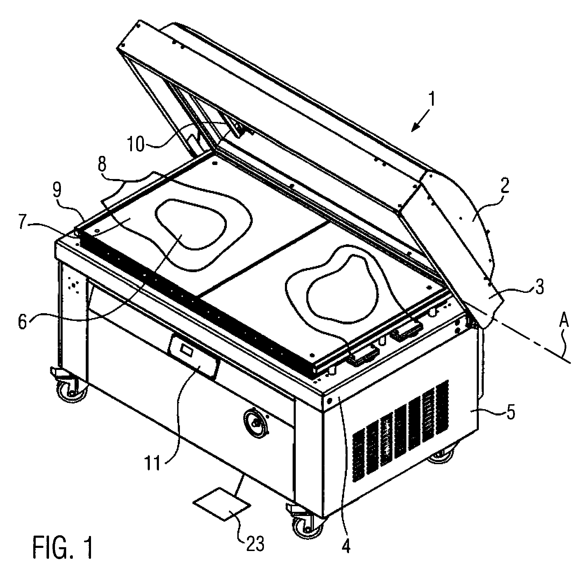

Fig. 1 zeigt eine Vakuum-Kammermaschine 1 mit einem geöffneten Kammerdeckel 2, der einen Schutzrahmen 3 umfasst. Der Kammerdeckel 2 ist um eine Achse A schwenkbar, um im geschlossenen Zustand mit einem Kammerunterteil 4, das auf einem Gestell 5 angeordnet ist, eine Vakuumkammer zu bilden. Bei geöffnetem Kammerdeckel 2 können mit Produkt 6 gefüllte Beutel 7 derart eingelegt werden, dass ein zu siegelnder Beutelhals 8 auf einem Siegelbalken 9 aufliegt. Bei geschlossenem Kammerdeckel 2 drückt eine im Kammerdeckel 2 angebrachte Siegelschiene 10 nach dem Evakuiervorgang den Beutelhals 8 gegen den Siegelbalken 9 und erzeugt eine gasdichte Siegelung des Beutels 7.

Der Schutzrahmen 3 ist beweglich am Kammerdeckel 2 angebracht, und nicht näher dargestellte Sensoren erfassen eine Bewegung bzw. eine Lageänderung gegenüber einer Grundstellung. Sollte sich beim Schließen bzw. nach unten Schwenken des Kammerdeckels 2 ein Arm oder eine Hand eines Bedieners oder ein Teil des Produktes 6 im Außenbereich des Kammerdeckels 2 und damit im Bereich des Schutzrahmens 3 befinden, so kommt der Schutzrahmen 3 mit dem betreffenden Teil in Kontakt. Während der weiteren Bewegung bzw. des Schließens des Kammerdeckels 2 bleibt der Schutzrahmen 3 auf dem Körperteil des Bedieners oder auf dem Produkt liegen. Die kraftangetriebene Schließbewegung des Kammerdeckels 2 ist noch aktiv, so dass eine Relativbewegung zwischen dem Schutzrahmen 3 und dem Kammerdeckel 2 vorliegt und der Schutzrahmen 3 sich nicht mehr in seiner Grundstellung befindet und dies durch Sensoren an die Steuerung 11 gemeldet wird. Eine Steuerung 11 stoppt daraufhin die Schließbewegung des Kammerdeckels 2, um Verletzungen beim Bediener oder Beschädigungen am Produkt zu verhindern.

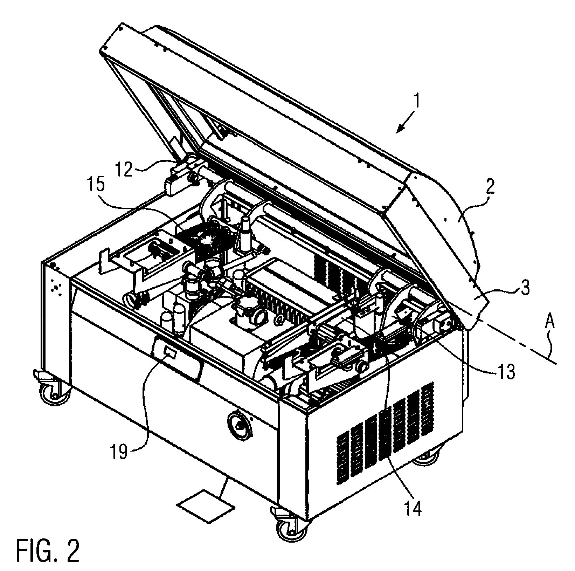

Fig. 2 zeigt den kraftbetriebenen Antrieb des Kammerdeckels 2. Der Kammerdeckel 2 ist mit einer Welle 12 verbunden und schwenkt um deren Achse A. An der Welle 12 sind zwei Paare von Hebeln 13 angebracht. Ein motorischer Antrieb 14 ist mit einem Hebel 13 verbunden und bewirkt über diesen Hebel 13 die Schwenkbewegung des Kammerdeckels 2 zum Öffnen und Schließen. Der motorische Antrieb 14 ist wenigstens mittelbar, beispielsweise über einen Leistungsschütz, mit der Steuerung 11 verbunden bzw. die Steuerung 11 ist dazu konfiguriert, den Antrieb 14 zu steuern. Zur Unterstützung der Kammerdeckelbewegungen bzw. zur Entlastung der Motorkraft des motorischen Antriebs 14 sind Federn 15, im speziellen Zugfedern, vorgesehen, die die Gewichtbelastung des Kammerdeckels 2 auf den motorischen Antrieb 14 reduzieren. Der motorische Antrieb 14 umfasst in diesem Ausführungsbeispiel einen Hubspindelmotor. Es sind aber alternative Antriebe, beispielsweise ein pneumatischer oder motorischer Linearantrieb, denkbar.

Bei der Schließbewegung des Kammerdeckels 2 werden die Federn 15 auf Zug belastet. Die Federn 15 sind an Federhalten 16 elektrisch isoliert angebracht, wobei die Federhalter 16 entweder am Gestell 5 oder an den Hebeln 13 angeordnet sind. Die Ausführung und die Anzahl der Federn 15 sind abhängig von den Gewichtskräften des Kammerdeckels 2 und bedingen auch die Höhe des benötigten Drehmoments bzw. die benötigte Kraft des Antriebs 14.

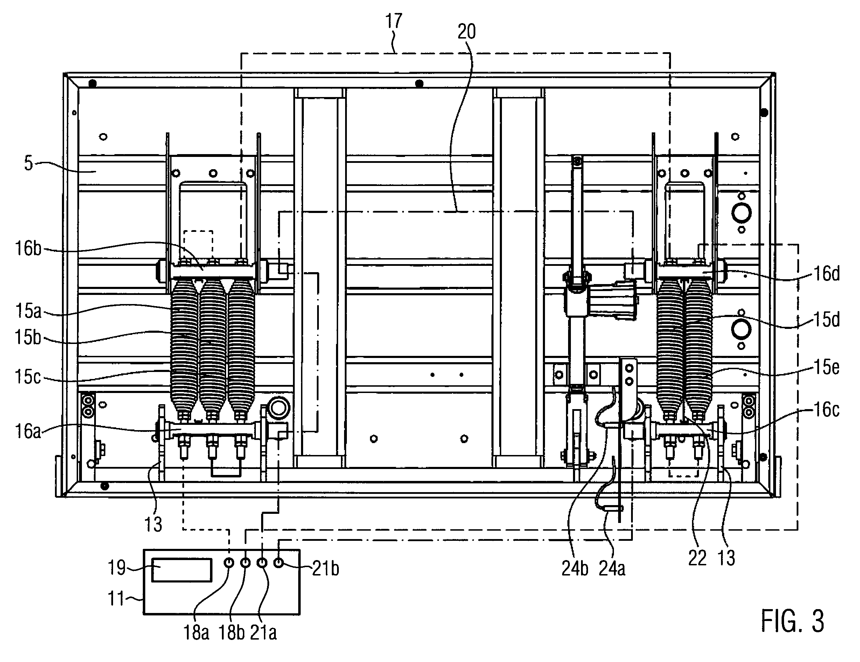

Im Falle eines Federbruchs einer oder mehrerer Federn 15 verringert sich die Entlastung der Gewichtskräfte des Kammerdeckels 2 und die Belastung auf den motorischen Antrieb 14 erhöht sich. Dabei ist es möglich, dass der Antrieb 14 den Kammerdeckel 2 noch öffnen kann, weil die Leistung des Antriebs 14 noch ausreichend ist. Beim normalen Schließvorgang kann der Bediener einen Federbruch aber nicht erkennen. Erst in einer Nothaltsituation durch Auslösen des Schutzrahmens 3 kann der Antrieb 14 den Kammerdeckel 2 möglicherweise nicht rechtzeitig anhalten, da die Kräfte des Kammerdeckels 2 auf den Antrieb 14 zu groß sind. Der für den Bremsvorgang benötigte Restweg des Kammerdeckels 2, bei dem der Kammerdeckel 2 sich noch innerhalb des Schutzrahmens 3 bewegt, kann in diesem Fall zu groß sein und Verletzungen beim Bediener sind nicht mehr ausgeschlossen. Um die Sicherheit zu erhöhen, ist eine Federbrucherkennung vorgesehen, die anhand der Fig. 3 näher erläutert wird.

Fig. 3 zeigt eine Ansicht von unten auf die Kammerdeckelverstellung. Auf der linken Seite der Fig. 3 sind drei Federn 15a, 15b, 15c und auf der rechten Seite zwei weitere Federn 15d und 15e gezeigt. Die linken Federn 15a, 15b, 15c sind mit ihren Enden an zwei Federhaltern 16a und 16b angebracht, wobei die Federn 15a, 15b, 15c dabei gegenüber den Federhaltern 16a, 16b elektrisch isoliert sind. Beispielsweise kann die elektrische Isolation über eine Kunststoffbuchse oder eine andere denkbare, elektrisch nicht-leitende Buchse oder ein nicht-leitendes Verbindungselement ausgeführt sein. Analog dazu sind die Federn 15d, 15e auf der rechten Seite an weiteren Federhaltern 16c, 16d elektrisch isoliert angebracht. Die Federhalter 16a, 16c sind ebenfalls elektrisch isoliert an den Hebeln 13 angeordnet. Mittels der Hebel 13 übertragen die Federn 15 ihre Zugkraft auf den Kammerdeckel 2. Die Federhalter 16a, 16c sind gegenüber allen Teilen der Vakuum-Kammermaschine 1 elektrisch isoliert. Die weiteren Federhalter 16b, 16d sind ebenso elektrisch isoliert am Gestell 5 angebracht, so dass alle Federhalter 16a, 16b, 16c, 16d elektrisch isoliert gegenüber allen Teilen der Vakuum-Kammermaschine 1 sind.

Die fünf Federn 15a bis 15e sind mit einem in der Fig. 3 gestrichelten ersten elektrischen Stromkreis 17 gemeinsam in Reihe mit der Steuerung 11 verbunden. Da alle Federn 15a bis 15e für sich elektrisch isoliert in der Vakuum-Kammermaschine 1 angebracht sind, stellen sie selbst jeweils einen Teil des ersten elektrischen Stromkreises 17 dar. Sollte eine Feder 15 gebrochen sein, so kann kein Strom mehr durch den ersten elektrischen Stromkreis 17 fließen. Die Steuerung 11 umfasst eine erste Ausgangsklemme 18a und eine erste Eingangsklemme 18b, an denen die beiden Enden des elektrischen Stromkreises 17 angeschlossen sind. Die Steuerung 11 kann zyklisch oder auch vor jedem Start der Kammerdeckelbewegung den ersten elektrischen Stromkreis 17 prüfen, indem eine elektrische Spannung von beispielsweise 12 V oder 24 V an der ersten Ausgangsklemme 18a angelegt wird und an der ersten Eingangsklemme 18b geprüft wird, ob eine sich unter Berücksichtigung des ohmschen Widerstandes der Feder 15 ergebende Spannung auch anliegt. Liegt an der ersten Eingangsklemme 18b keine Spannung an, so kann die Steuerung 11 daran ermitteln, ob wenigstens eine Feder 15 gebrochen ist. Ist dies der Fall, so wird der Start der Kammerdeckelbewegung nicht freigegeben und eine entsprechende Fehlermeldung oder ein Fehlercode an einer Anzeige 19 der Steuerung 11 für den Bediener ausgegeben. Alternativ oder zusätzlich kann die Stromstärke an der ersten Ausgangsklemme 18a und an der ersten Eingangsklemme 18b gemessen werden. Stimmen diese beiden Stromstärken miteinander überein, ist dies ein Beleg dafür, dass in dem ersten Stromkreis 17 keine Verluste auftreten. Die Steuerung 11 kann daraus schlussfolgern, dass kein Stromkreis 17 vorliegt. Analog kann ein Federbruch erkannt werden, wenn unterschiedliche erste Stromkreise 17 für jeweils eine oder mehrere Federn 15 vorgesehen sind.

Sollten beispielsweise mehrere Isolationen zwischen den Federn 15a bis 15c und den Federhaltern 16a, 16b defekt sein, so könnte der erste elektrische Stromkreis 17 geschlossen sein, obwohl eine Feder 15 gebrochen ist, da der Strom über einen Federhalter 16a, 16b fließen kann. In diesem Fall würde an der ersten Eingangsklemme 18b trotz einer gebrochenen Feder die Spannung der Ausgangsklemme 18a anliegen können. Um diesen Fehlerfall auch noch erkennen und damit ausschließen zu können, ist ein als Strich-Punkt-Linie dargestellter zweiter elektrischer Stromkreis 20 vorgesehen, der die Enden der elektrisch isolierten Federhalter 16a bis 16d in Reihe verbindet. Der zweite elektrische Stromkreis 20 ist analog zum ersten Stromkreis 17 über eine zweite Ausgangsklemme 21 a und eine zweite Eingangsklemme 21 b mit der Steuerung 11 verbunden. Ein erster Test des zweiten Stromkreises 20 erfolgt über eine Spannung von 12V oder 24V an der zweiten Ausgangsklemme 21a. Solange bei der zweiten Eingangsklemme 21 b die um den erwarteten Spannungsabfall an den Federhaltern 16 verminderte Spannung anliegt, ist sichergestellt, dass in dem zweiten Stromkreis 20 kein Kabelbruch vorliegt und dieser Stromkreis 20 in Ordnung ist. Ein zweiter Test erfolgt während des Federbruchtests. Dabei wird an der ersten Ausgangsklemme 18a eine Spannung angelegt und an den beiden Eingangsklemmen 18b und 21 b ermittelt, ob dort jeweils Spannung anliegt. Alternativ kann auch über Strommessungen an den Ausgangs- und Eingangsklemmen ermittelt werden, ob die jeweiligen Stromkreise 17, 20 intakt oder unterbrochen und damit defekt sind.

Folgende Varianten an den Eingangsklemmen führen zu folgenden Ergebnissen:

| **Eingang 18b** | **Eingang 21b** | **Ergebnis** |
|---|---|---|
| Spannung/gleiche Stromstärke wie an Ausqanq 18a | keine Spannung/ kein Stromfluss | Kein Federbruch |
| Spannung/gleiche Stromstärke wie an Ausgang 18a | Spannung/ Stromfluss vorhanden | Isolation an wenigstens einer Feder defekt |
| keine Spannung/ kein Stromfluss | keine Spannung/ kein Stromfluss | Federbruch erkannt |
| keine Spannung/ kein Stromfluss | Spannung/ Stromfluss vorhanden | Federbruch erkannt und die Isolation an wenigstens einer Feder ist defekt |

Somit ist sichergestellt, dass ein Leitungsbruch, ein Federbruch oder eine defekte Isolierung mittels des ersten 17 und zweiten elektrischen Stromkreises 20 und der zwei Ausgangsklemmen 18a, 21a sowie der zwei Eingangsklemmen 18b, 21b über die Steuerung 11 ermittelt werden können.

Die Überprüfung des zweiten elektrischen Stromkreises 20 über die Spannung an der zweiten Ausgangsklemme 21a kann beispielsweise nach jedem Einschalten der Vakuum-Kammermaschine 1 erfolgen, zyklisch in einem Abstand von 1 Minute oder vor jedem Start der Kammerdeckelbewegung bzw. vor jeder Prüfung der Federn 15.

Die Überprüfung auf Federbruch und defekte Isolationen erfolgt zeitgleich durch die Spannung an der ersten Ausgangsklemme 18a und den beiden Eingangsklemmen 18b, 21 b, wenigstens vor jedem Schließvorgang des Kammerdeckels 2 und vorzugsweise auch nach jedem Schließvorgang in der geschlossen Stellung.

Um den Fall auszuschließen, dass zwei benachbarte Federn 15 zwischen zwei aufeinanderfolgenden Prüfzyklen brechen und danach in Kontakt stehen und dann in Folge der Federbruch nicht erkannt wird, kann entweder eine elektrisch nicht-leitende Zwischenwand 22 oder ein ausreichender Abstand der Federn 15 vorgesehen werden.

Die Kammerdeckelbewegung kann über einen Fußtaster 23 (auch in Fig. 1 gezeigt), der mit der Steuerung 11 verbunden ist, eingeleitet und/oder direkt über die Steuerung 11 nach dem Evakuiervorgang gestartet werden.

Die geöffnete Stellung des Kammerdeckels 2 kann über einen ersten Sensor 24a und die geschlossene Stellung, bei der die Beutel 7 evakuiert und gesiegelt werden, über einen zweiten Sensor 24b erfasst werden, wobei beide Sensoren 24a, 24b mit der Steuerung 11 verbunden sind.

Es ist auch eine Vakuum-Kammermaschine 1 umfasst, die keinen Schutzrahmen 3 aufweist oder die statt des Schutzrahmens 3 ein alternatives System mit Sensoren, beispielsweise Lichtschranken, zur Erkennung von Körperteilen während der Deckelschließbewegung aufweist.

## Patentansprüche

1. Vakuum-Kammermaschine (1), umfassend ein Gestell (5), eine Steuerung (11) und einen Kammerdeckel (2), wobei der Kammerdeckel (2) mittels eines kraftbetriebenen Antriebs (14) schwenkbar ist, wobei mehrere Federn (15) vorgesehen sind, um den Antrieb (14) wirkungsmäßig zu unterstützen, **dadurch gekennzeichnet, dass** jede der Federn (15) als Abschnitt eines elektrischen Stromkreises (17) mit der Steuerung (11) elektrisch verbunden ist, wobei durch eine Änderung des in dem Stromkreis (17) fließenden Stroms oder der über den Stromkreis (17) anliegenden Spannung ein Federbruch erkennbar ist.

2. Vakuum-Kammermaschine nach Anspruch 1, **dadurch gekennzeichnet, dass** die Federn (15) elektrisch isoliert an Federhaltern (16) angebracht sind.

3. Vakuum-Kammermaschine nach Anspruch 2, **dadurch gekennzeichnet, dass** die Federhalter (16) elektrisch isoliert sind gegenüber dem Gestell (5) und den Federn (15).

4. Vakuum-Kammermaschine nach Anspruch 3, **dadurch gekennzeichnet, dass** die Federhalter (16) mittels einer zweiten elektrischen Leitung (20) in Reihe miteinander und mit der Steuerung (11) elektrisch verbunden sind, um eine fehlerhafte Isolierung wenigstens einer Feder (15) an einem Federhalter (16) ermitteln zu können.

5. Vakuum-Kammermaschine nach einem der Ansprüche 2 bis 4, **dadurch gekennzeichnet, dass** die gesamte Länge einer Feder (15) zwischen einem ersten Federhalter (16a, 16c) und einem zweiten Federhalter (16b, 16d) einen Abschnitt des elektrischen Stromkreises (17) bildet.

6. Vakuum-Kammermaschine nach einem der vorangehenden Ansprüche, **dadurch gekennzeichnet, dass** mehrere Federn (15) oder sogar alle Federn (15) Teil eines gemeinsamen elektrischen Stromkreises (17) sind.

7. Vakuum-Kammermaschine nach Anspruch 6, **dadurch gekennzeichnet, dass** mehrere elektrische Federn (15) innerhalb eines gemeinsamen elektrischen Stromkreises (17) in Reihe miteinander verbunden sind.

8. Vakuum-Kammermaschine nach einem der vorangehenden Ansprüche, **dadurch gekennzeichnet, dass** die Steuerung (11) dazu konfiguriert ist, bei Erkennen eines Federbruchs den Antrieb (14) abzuschalten oder eine Schließbewegung des Kammerdeckels (2) nicht zuzulassen und/oder eine Fehlerinformation an einer Anzeige (19) der Steuerung (11) auszugeben.

9. Vakuum-Kammermaschine nach einem der vorangehenden Ansprüche, **dadurch gekennzeichnet, dass** der Antrieb (14) einen Servomotor, einen Spindelmotor oder einen Linearmotor aufweist.

10. Vakuum-Kammermaschine nach einem der vorangehenden Ansprüche, **dadurch gekennzeichnet, dass** der Antrieb (14) über einen Fußtaster (23) und/oder die Steuerung (11) aktivierbar ist.

11. Vakuum-Kammermaschine nach einem der vorangehenden Ansprüche, **dadurch gekennzeichnet, dass** der Kammerdeckel (2) einen relativ zum Kammerdeckel (2) bewegbaren Schutzrahmen (3) aufweist.

12. Verfahren zum Ermitteln eines Federbruchs in einer Vakuum-Kammermaschine (1), wobei mehrere Federn (15) zum wirkungsmäßigen Unterstützen eines kraftbetriebenen Antriebs (14) zum Schwenken eines Kammerdeckels (2) vorgesehen sind, wobei jede der Federn (15) über einen ersten elektrischen Stromkreis (17) elektrisch mit einer Steuerung (11) verbunden ist und der Stromkreis (17) an einer ersten Ausgangsklemme (18a) sowie an einer ersten Eingangsklemme (18b) der Steuerung (11) angeschlossen ist, wobei das Verfahren folgende Schritte aufweist:
- Anlegen einer elektrischen Spannung an der ersten Ausgangsklemme (18a),
- Prüfen, ob an der ersten Eingangsklemme (18b) die Spannung anliegt,
- Freigabe des Antriebs (14) für den Kammerdeckel (2) durch die Steuerung (11), wenn dort eine vorgegebene Spannung anliegt oder die Stromstärke an der ersten Eingangsklemme genau so groß ist wie an der ersten Ausgangsklemme (18a).

13. Verfahren nach Anspruch 12, **dadurch gekennzeichnet, dass** folgende Schritte zur Prüfung der Isolation von Federn (15) gegenüber Federhaltern (16) vorgesehen sind, wobei die Federhalter (16) über eine zweite elektrische Leitung (20) in Reihe miteinander verbunden sind und die zweite Leitung (20) mit einer zweiten Ausgangsklemme (21a) und mit einer zweiten Eingangsklemme (21 b) der Steuerung (11) verbunden ist:
- Anlegen einer elektrischen Spannung an der ersten Ausgangsklemme (18a),
- Prüfen, ob an der ersten Eingangsklemme (18b) und an der zweiten Eingangsklemme (21 b) die Spannung anliegt,
- Freigabe des Antriebs (14), falls kein Federbruch und keine defekte Isolation einer Feder durch die Steuerung (11) festgestellt wurde,
- Ausgabe einer Fehlerinformation an einer Anzeige (19) der Steuerung (11), falls ein Federbruch oder eine defekte Isolation einer Feder (15) durch die Steuerung (11) festgestellt wurde, wobei der Antrieb (14) nicht freigegeben wird.

14. Verfahren nach Anspruch 12 oder 13, **dadurch gekennzeichnet, dass** die an der ersten Ausgangsklemme (18a) anliegende elektrische Spannung 20V bis 35V beträgt.

15. Verfahren nach einem der Ansprüche 12 bis 14, **dadurch gekennzeichnet, dass** der Antrieb (14) über einen Fußtaster (23) und/oder die Steuerung (11) aktiviert wird.

## Claims

1. Vacuum chamber machine (1) comprising a frame (5), a controller (11) and a chamber lid (2), where said chamber lid (2) is pivotable by a power-operated drive (14), where a plurality of springs (15) is provided to operatively support said drive (14), **characterized in that** each of said springs (15) is electrically connected to said controller (11) as a section of an electric circuit (17), where a spring fracture is detectable via a change of the current flowing in the electric circuit (17) or via the voltage applied to the electric circuit (17).

2. Vacuum chamber machine according to claim 1, **characterized in that** said springs (15) are attached to spring holders (16) in an electrically insulated manner.

3. Vacuum chamber machine according to claim 2, **characterized in that** said spring holders (16) are electrically insulated from said frame (5) and said springs (5).

4. Vacuum chamber machine according to claim 3, **characterized in that** said spring holders (16) are, by a second electrical line (20), electrically connected in series to each other and to said controller (11) to be able to detect an insulation fault of at least one spring (15) at a spring holder (16).

5. Vacuum chamber machine according to one of the claims 2 through 4, **characterized in that** the entire length of a spring (15) between a first spring holder (16a, 16c) and a second spring holder (16b, 16d) forms a section of said electric circuit (17).

6. Vacuum chamber machine according to one of the preceding claims, **characterized in that** a plurality of springs (15) or even all of said springs (15) are part of a common electric circuit (17).

7. Vacuum chamber machine according to claim 6, **characterized in that** a plurality of electric springs (15) are in a common electric circuit (17) connected to each other in series.

8. Vacuum chamber machine according to one of the preceding claims, **characterized in that** said controller (11) is configured to switch off said drive (14) or to not allow a closing movement of said chamber lid (2) when detecting a spring fracture and / or to output error information to a display (19) of said controller (11).

9. Vacuum chamber machine according to one of the preceding claims, **characterized in that** said drive (14) comprises a servo motor, a spindle motor or a linear motor.

10. Vacuum chamber machine according to one of the preceding claims, **characterized in that** said drive (14) is activatable via a foot switch (23) and / or by said controller (11).

11. Vacuum chamber machine according to one of the preceding claims, **characterized in that** said chamber lid (2) comprises a protective frame (3) moveable relative to said chamber lid (2).

12. Method for detecting a spring fracture in a vacuum chamber machine (1), wherein a plurality of springs (15) is provided for operatively supporting a power-operated drive (14) for pivoting a chamber lid (2), where each of said springs (15) is electrically connected to a controller (11) via a first electric circuit (17), and said electric circuit (17) is connected to a first output terminal (18a) and to a first input terminal (18b) of said controller (11), said method comprising the steps of:
- applying an electrical voltage to said first output terminal (18a),
- testing whether a voltage is present at said first input terminal (18b),
- enabling said drive (14) for said chamber lid (2) via said controller (11) when there is a predetermined voltage present or when said current at said first input terminal is equal to that at said first output terminal.

13. Method according to claim 12, **characterized in that** the following steps are provided for checking the insulation of springs (15) from said spring holders (16), wherein said spring holders (16) are via a second electrical line (20) connected in series to each other and said second line (20) is connected to a second output terminal (21a) and to a second input terminal (21 b) of said controller (11):
- applying an electrical voltage to said first output terminal (18a),
- testing whether a voltage is present at said first input terminal (18b) and at said second input terminal (21 b),
- enabling said drive (14) if no spring fracture and no defective insulation of a spring is detected by said controller (11),
- outputting error information to a display (19) of said controller (11) in the event that a spring fracture or a defective insulation of a spring (15) was detected by said controller (11), and disabling said drive (14).

14. Method according to claim 12 or 13, **characterized in that** said electrical voltage applied at said first output terminal (18a) is at 20V to 35V.

15. Method according to one of the claims 12 through 14, **characterized in that** said drive (14) is activated via a foot switch (23) and / or by said controller (11).

## Revendications

1. Machine d'emballage sous vide à chambre (1), comprenant un bâti (5), une commande (11) et un couvercle de chambre (2), le couvercle de chambre (2) pouvant pivoter au moyen d'un entraînement mécanique motorisé (14), plusieurs ressorts (15) étant prévus pour assister de manière active l'entraînement (14), **caractérisée en ce que** chacun des ressorts (15) est relié électriquement à la commande (11), en tant que tronçon d'un circuit de courant électrique (17), une variation du courant qui circule dans le circuit de courant (17) ou de la tension aux bornes du circuit de courant (17) permettant de déceler une rupture de ressort.

2. Machine d'emballage sous vide à chambre selon la revendication 1, **caractérisée en ce que** les ressorts (15) sont placés de manière électriquement isolée sur des supports de ressort (16).

3. Machine d'emballage sous vide à chambre selon la revendication 2, **caractérisée en ce que** les supports de ressort (16) sont isolés électriquement par rapport au bâti (5) et aux ressorts (15).

4. Machine d'emballage sous vide à chambre selon la revendication 3, **caractérisée en ce que** les supports de ressort (16) sont reliés électriquement, au moyen d'un deuxième conducteur (20), en série les uns avec les autres et avec la commande (11), en vue de pouvoir déterminer un défaut d'isolation d'au moins un ressort (15) au niveau d'un support de ressort (16).

5. Machine d'emballage sous vide à chambre selon l'une des revendications 2 à 4, **caractérisée en ce que** la totalité de la longueur d'un ressort (15) entre un premier support de ressort (16a, 16c) et un deuxième support de ressort (16b, 16d) forme un tronçon du circuit de courant électrique (17).

6. Machine d'emballage sous vide à chambre selon l'une des revendications précédentes, **caractérisée en ce que** plusieurs ressorts (15), voire tous les ressorts (15), font partie d'un circuit de courant électrique (17) commun.

7. Machine d'emballage sous vide à chambre selon la revendication 6, **caractérisée en ce que** plusieurs ressorts électriques (15) sont reliés mutuellement en série à l'intérieur d'un circuit de courant électrique (17) commun.

8. Machine d'emballage sous vide à chambre selon l'une des revendications précédentes, **caractérisée en ce que** la commande (11) est configurée pour, lors de la détection d'une rupture de ressort, arrêter l'entraînement (14) ou ne pas autoriser un mouvement de fermeture du couvercle de chambre (2) et/ou délivrer une information de défaut au niveau d'un affichage de visualisation (19) de la commande (11).

9. Machine d'emballage sous vide à chambre selon l'une des revendications précédentes, **caractérisée en ce que** l'entraînement (14) comprend un servomoteur, un moteur à vis ou un moteur linéaire.

10. Machine d'emballage sous vide à chambre selon l'une des revendications précédentes, **caractérisée en ce que** l'entraînement (14) peut être rendu actif par l'intermédiaire d'un poussoir à pied (23) et/ou de la commande (11).

11. Machine d'emballage sous vide à chambre selon l'une des revendications précédentes, **caractérisée en ce que** le couvercle de chambre (2) comporte un cadre de protection (3) mobile par rapport au couvercle de chambre (2).

12. Procédé pour déterminer ou détecter une rupture de ressort dans une machine d'emballage sous vide à chambre (1), plusieurs ressorts (15) étant prévus pour assister de manière active un entraînement mécanique motorisé (14) destiné à faire pivoter un couvercle de chambre (2), chacun des ressorts (15) étant relié électriquement à une commande (11) par l'intermédiaire d'un premier circuit de courant électrique (17), et le circuit de courant (17) étant raccordé à une première borne de sortie (18a) ainsi qu'à une première borne d'entrée (18b) de la commande (11), le procédé présentant les étapes suivantes :
- appliquer une tension électrique à la première borne de sortie (18a),
- vérifier si la tension est présente au niveau de la première borne d'entrée (18b),
- libérer l'entraînement (14) pour le couvercle de chambre (2) par la commande (11), lorsqu'on est ici en présence d'une tension prescrite à l'avance ou que l'intensité de courant au niveau de la première borne d'entrée est exactement aussi grande qu'au niveau de la première borne de sortie (18a).

13. Procédé selon la revendication 12, **caractérisé en ce que** sont prévues les étapes suivantes, pour vérifier l'isolation de ressorts (15) par rapport à des supports de ressort (16), les supports de ressort (16) étant reliés en série les uns aux autres par l'intermédiaire d'un deuxième conducteur électrique (20) et le deuxième conducteur électrique (20) étant relié à une deuxième borne de sortie (21a) et à une deuxième borne d'entrée (21b) de la commande (11) :
- appliquer une tension électrique à la première borne de sortie (18a),
- vérifier si la tension est présente au niveau de la première borne d'entrée (18b) et au niveau de la deuxième borne d'entrée (21b),
- libérer l'entraînement (14) lorsqu'aucune rupture de ressort et aucun défaut d'isolation d'un ressort n'a été détecté par la commande (11),
- délivrer une information de défaut au niveau d'un affichage de visualisation (19) de la commande (11), lorsqu'une rupture de ressort ou un défaut d'isolation d'un ressort (15) a été détecté par la commande (11), l'entraînement (14) n'étant alors pas libéré.

14. Procédé selon la revendication 12 ou la revendication 13, **caractérisé en ce que** la tension électrique appliquée à la première borne de sortie (18a) a une valeur de 20V à 35V.

15. Procédé selon l'une des revendications 12 à 14, **caractérisé en ce que** l'entraînement (14) est rendu actif par l'intermédiaire d'un poussoir à pied (23) et/ou de la commande (11).
